(19) Europäisches Patentamt
European Patent Office
Office européen des brevets

(11) **EP 1 709 696 B1**

(12) **EUROPÄISCHE PATENTSCHRIFT**

(45) Veröffentlichungstag und Bekanntmachung des Hinweises auf die Patenterteilung:
**19.08.2009 Patentblatt 2009/34**

(21) Anmeldenummer: **04821078.5**

(22) Anmeldetag: **18.11.2004**

(51) Int Cl.:
*H01L 41/083* (2006.01)　　　*H01L 41/053* (2006.01)

(86) Internationale Anmeldenummer:
**PCT/EP2004/053004**

(87) Internationale Veröffentlichungsnummer:
**WO 2005/069394 (28.07.2005 Gazette 2005/30)**

(54) **PIEZOELEKTRISCHER AKTOR**

PIEZOELECTRIC ACTUATOR

ACTIONNEUR PIEZOELECTRIQUE

(84) Benannte Vertragsstaaten:
**DE FR GB IT**

(30) Priorität: **15.01.2004 DE 102004002133**

(43) Veröffentlichungstag der Anmeldung:
**11.10.2006 Patentblatt 2006/41**

(73) Patentinhaber: **ROBERT BOSCH GMBH**
**70442 Stuttgart (DE)**

(72) Erfinder:
• **WALTER, Gerhard**
**70839 Gerlingen (DE)**

• **MANN, Armin**
**71634 Ludwigsburg (DE)**

(56) Entgegenhaltungen:
**EP-A- 0 144 655**　　　**EP-A- 1 233 461**
**WO-A-03/026033**　　　**WO-A-20/05053046**
**DE-A1- 10 163 005**

• **PATENT ABSTRACTS OF JAPAN Bd. 1995, Nr. 09, 31. Oktober 1995 (1995-10-31) -& JP 07 154005 A (TOKIN CORP), 16. Juni 1995 (1995-06-16)**

## Beschreibung

Stand der Technik

Die Erfindung geht aus von einem piezoelektrischen Aktor nach der Gattung des Hauptanspruchs. Es sind schon Piezoaktoren, beispielsweise aus der DE 198 38 862 A1, bekannt mit piezoelektrischen Keramikschichten, die übereinander zu einem Multilayerstapel geschichtet angeordnet sind, wobei die piezoelektrischen Keramikschichten Elektrodenschichten aufweisen, wobei zwischen den piezoelektrischen Keramikschichten jeweils eine Elektrodenschicht vorgesehen ist, wobei an den stirnseitigen Enden des Piezoaktors jeweils eine äußere Deckschicht angeordnet ist und wobei die piezoelektrischen Keramikschichten und die äußeren Deckschichten jeweils eine vorbestimmte Dielektrizitätszahl aufweisen. Die äußeren Deckschichten dienen als sogenannte passive Schichten u.a. der Isolation und des Toleranzausgleichs und bestehen aus unpolarisierter Piezokeramik. Die äußeren Deckschichten sind mechanisch bearbeitet, um koplanare Oberflächen zu erzeugen und weisen eine größere Schichtdicke auf als die piezoelektrischen Keramikschichten zwischen den äußeren Deckschichten.

Piezoaktoren werden von einem Steuergerät mit hoher Frequenz vorteilhaft getaktet angesteuert. Durch die schnellen Schaltvorgänge entstehen erhebliche elektromagnetische Störungen, die durch aufwendige Maßnahmen am Steuergerät oder an den elektrischen Zuleitungen der Piezoaktoren verringert werden müssen. Beispielsweise werden zur Entstörung Entstördrosseln und/oder Entstörkondensatoren an Steckeranschlüssen, sogenannte Snubber-Netzwerke an den Schaltelementen, schaltflankenbegrenzende Maßnahmen oder abgeschirmte und/oder verdrillte elektrische Zuleitungen zu den Piezoaktoren eingesetzt.

WO 2005/053046 A offenbart einen piezoelektrischen Aktor mit piezoelektrischen Keramikschichten, wobei an den stirnseitigen Enden des Aktors jeweils eine äußere Deckschicht angeordnet ist, wobei die piezoelektrischen Keramikschichten und die äußeren Deckschichten jeweils eine vorbestimmte Dielektrizitätskonstante aufweisen und wobei die äußeren Deckschichten eine geringere relative Dielektrizitätskonstante aufweisen als die piezoelektrischen Keramikschichten zwischen den äußeren Deckschichten.

Vorteile der Erfindung

Der erfindungsgemäße piezoelektrische Aktor mit den kennzeichnenden Merkmalen des Hauptanspruchs hat demgegenüber den Vorteil, daß auf einfache Art und Weise die elektromagnetischen Störungen verringert werden, indem die äußeren Deckschichten eine geringere Dielektrizitätszahl aufweisen als die piezoelektrischen Keramikschichten zwischen den äußeren Deckschichten und die äußeren Deckschichten jeweils mit einem Deckel eines den Aktor umgebenden Zylinders verbunden sind. Auf diese Weise können die elektromagnetischen Störungen viel kostengünstiger und wirkungsvoller verringert werden als beim Stand der Technik. Durch die in den Unteransprüchen aufgeführten Maßnahmen sind vorteilhafte Weiterbildungen und Verbesserungen des im Hauptanspruch angegebenen piezoelektrischen Aktors möglich.

In den Ausführungsbeispielen sind die äußeren Deckschichten vorteilhafterweise mit jeweils einer Elektrodenschicht benachbart oder an einer Keramikschicht angeordnet. Bei einer ersten vorteilhaften Ausführung sind die erfindungsgemäßen äußeren Deckschichten jeweils an einer Elektrodenschicht angeordnet. Hierbei werden die äußeren Keramikschichten eines piezoelektrischen Aktors nach dem Stand der Technik durch erfindungsgemäße äußere Deckschichten ersetzt. Hierbei ist kein Zusatzprozeß bei der Herstellung des Aktors notwendig. Bei einem Aktor nach dem Stand der Technik können die elektromagnetischen Störungen verringert werden, indem erfindungsgemäße äußere Deckschichten zusätzlich an den äußeren Keramikschichten des Aktors angeordnet werden. Dies erfordert einen Zusatzprozeß bei der Herstellung des Aktors oder vor der Montage des Aktors in sein Gehäuse.

Weiterhin vorteilhaft ist, wenn die äußeren Deckschichten aus einer piezoelektrischen Keramik hergestellt sind, da auf diese Weise kein Zusatzprozeß oder zusätzliche Bauteile bei der Herstellung des piezoelektrischen Aktors notwendig ist.

In einem vorteilhaften Ausführungsbeispiel ist die relative Dielektrizitätskonstante $\varepsilon_r$ der piezoelektrischen Keramik der äußeren Deckschichten durch Zumischen von geeigneten Zusatzstoffen oder durch eine andere Veränderung der Materialzusammensetzung verringert.

Auch vorteilhaft ist, wenn die äußeren Deckschichten jeweils durch Beschichten, Kleben oder Löten mit einer Keramikschicht verbunden sind, da dies besonders einfache Ausführungsformen sind.

Sehr vorteilhaft ist, wenn der Aktor an den äußeren Deckschichten zwischen zwei Deckeln auf Druck vorgespannt ist, wobei die Deckel jeweils eine der äußeren Deckschicht des Aktors zugewandte weitere Isolierschicht aufweisen, die eine geringere relative Dielektrizitätskonstante $\varepsilon_r$ aufweist als die äußeren Deckschichten des Aktors. Auf diese Weise können die elektromagnetischen Störungen verringert werden, ohne den piezoelektrischen Aktor nach dem Stand der Technik verändern zu müssen.

Zeichnung

Ausführungsbeispiele der Erfindung sind in der Zeichnung vereinfacht dargestellt und in der nachfolgenden Beschreibung näher erläutert. Fig.1 zeigt einen piezoelektrischen Aktor gemäß einem ersten Ausführungsbeispiel, Fig.2 einen piezoelektrischen Aktor gemäß einem zweiten Ausführungsbeispiel und Fig.3 einen piezoelektrischen Aktor gemäß einem dritten Ausführungsbeispiel.

Beschreibung der Ausführungsbeispiele

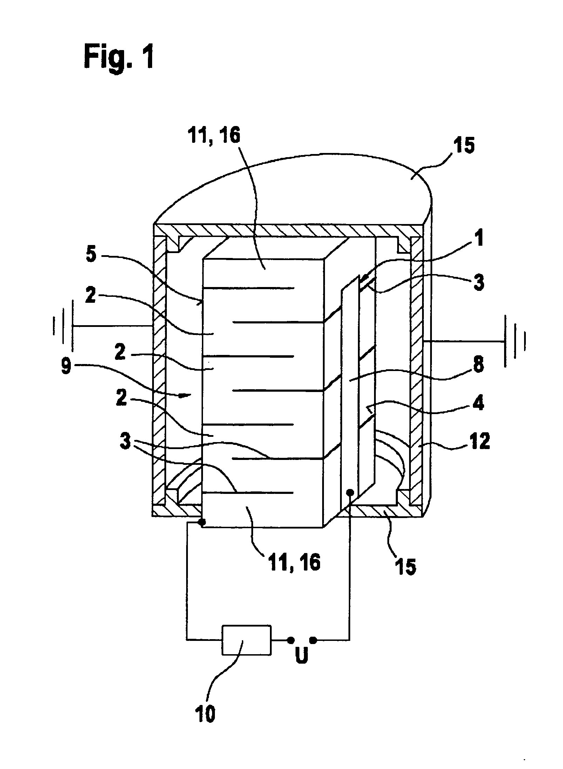

In Fig.1 ist schematisch ein piezoelektrischer Aktor 1 dargestellt, der aus einer Vielzahl von aufeinander geschichteten Keramikschichten 2 zusammengesetzt ist, die übereinander geschichtet einen sogenannten Multilayer-Stapel bilden. Der piezoelektrische Aktor erstreckt sich dabei in Richtung einer Aktorachse 6.

Zwischen den piezoelektrischen Keramikschichten 2 ist jeweils eine Elektrodenschicht 3 vorgesehen, die beispielsweise auf die Keramikschichten 2 mittels Siebdrucktechnik aufgedruckt sind. Die Keramikschichten 2 sind elektrisch nichtleitend und polarisierbar.

Gemäß dem ersten und zweiten Ausführungsbeispiel weist der Aktor 1 an seinen stirnseitigen Enden jeweils eine äußere Deckschicht 11 auf. Die äußeren Deckschichten 11 sind beispielsweise mit dem Aktor 1 stoffschlüssig und/oder kraftschlüssig verbunden. Gemäß dem ersten Ausführungsbeispiel sind die äußeren Deckschichten 11 als äußere Keramikschichten 16 ausgebildet. Die äußeren Keramikschichten 16 werden auch als passive Schichten bezeichnet, da sie nur einseitig von einer Elektrodenschicht 3 benachbart sind und beispielsweise eine nicht polarisierte Keramik aufweisen. Die Keramikschichten 2 zwischen den äußeren Keramikschichten 16 sind dagegen polarisiert, jeweils zu zwei Elektrodenschichten 3 benachbart und werden daher als aktive Schichten bezeichnet.

Der piezoelektrische Aktor 1 ist beispielsweise quaderförmig oder zylinderförmig ausgebildet, wobei die Keramikschichten 2 beispielsweise quadratisch oder kreisförmig sind. Die Elektrodenschichten 3 sind aus elektrisch leitendem Material, beispielsweise Silberpalladium, Silber, Kupfer oder Gold, hergestellt und werden auch als Innenelektroden bezeichnet.

Die Elektrodenschichten 3 sind derart angeordnet, daß sie abwechselnd entweder von einer ersten Anschlußfläche 4 des Aktors 1 oder von einer der ersten Anschlußfläche 4 gegenüberliegenden zweiten Anschlußfläche 5 des Aktors 1 ausgehend in Richtung der Keramikschichten 2 verlaufen und bis nahe der jeweils gegenüberliegenden Anschlußfläche 4,5 reichen. Die von der ersten Anschlußfläche 4 ausgehenden Elektrodenschichten 3 sind mit einer ersten Außenelektrode 8 und die von der zweiten Anschlußfläche 5 ausgehenden Elektrodenschichten 3 sind mit einer zweiten Außenelektrode 9 elektrisch verbunden, wobei die Außenelektroden 8,9 beispielsweise in Form einer elektrisch leitenden Schicht an den Anschlußflächen 4,5 angeordnet sind. Zwischen den Außenelektroden 8,9 kann eine elektrische Spannung angelegt sein, die beispielsweise mittels eines elektronischen Steuergerätes 10 beispielsweise getaktet ein- oder abgeschaltet wird. Beim Anliegen einer Spannung zwischen den Außenelektroden 8,9 wird in bekannter Weise eine Längung des Aktors 1 um einen Hub bewirkt.

Der piezoelektrische Aktor 1 ist bekannterweise von einem mit elektrischer Masse verbundenen Zylinder 12, der ein Aktorgehäuse bildet, umgeben. Der Zylinder 12 ist beispielsweise als eine bekannte Rohrfeder ausgebildet. Zwischen dem Zylinder 12 und dem Aktor 1 kann eine elektrisch nicht leitende Vergußmasse zur Verbesserung der Wärmeableitung vorgesehen sein. Der Zylinder 12 ist stirnseitig jeweils mit einem Deckel 15 verschlossen, wobei die Deckel 15 stoffschlüssig und/ oder kraftschlüssig mit dem Zylinder 12 verbunden sind. Der Zylinder 12 und die Deckel 15 sind beispielsweise aus Metall hergestellt.

Der Aktor 1 ist beispielsweise zwischen den Deckeln 15 auf Druck vorgespannt, d.h. der Zylinder 12 übt über die Deckel 15 eine Druckkraft auf den Aktor 1 aus, wobei die stirnseitigen Enden des Aktors 1 jeweils an einem der Deckel 15 anliegen.

Der Aktor 1 wird von dem Steuergerät 10 in Abhängigkeit von Betriebsparametern mit hoher Frequenz getaktet ein- oder ausgeschaltet, wobei durch sogenannte Störkapazitäten gegen Masse ungewollt Störströme und Störspannungen erzeugt werden. Die durch die Störkapazitäten hervorgerufenen elektromagnetischen Störungen führen zur Störung von elektrischen Vorrichtungen, beispielsweise des Radioempfangs, und müssen deshalb verringert werden.

Beispielsweise wird zwischen dem Zylinder 12 und dem Aktor 1 eine erste Störkapazität $C_1$ gebildet, wobei die dem Zylinder 12 zugewandten Seitenflächen der Elektrodenschichten 3 eine erste Kondensatorplatte und der Zylinder 12 eine zweite Kondensatorplatte bilden. Der Raum zwischen dem Zylinder 12 und dem Aktor 1 bildet ein sogenanntes Dielektrikum.

Die erste Störkapazität $C_1$ ist jedoch klein und erzeugt nur geringe elektromagnetische Störungen, da die dem Zylinder 12 zugewandten Seitenflächen der Elektrodenschichten 3 wegen der geringen Dicke der Elektrodenschichten 3 klein und der Abstand zwischen dem Zylinder 12 und dem Aktor 1 groß ist. Außerdem ist die sogenannte relative Dielektrizitätskonstante $\varepsilon_r$ des Dielektrikums zwischen dem Zylinder 12 und dem Aktor 1 gering. Die erste Störkapazität $C_1$ wird nicht durch die Erfindung beeinflußt.

Eine zweite Störkapazität $C_2$ besteht jeweils zwischen den Deckeln 15 und der dem jeweiligen Deckel 15 nächsten Elektrodenschicht 3, wobei der Deckel 15 eine erste Kondensatorplatte und die dem Deckel 15 nächste Elektrodenschicht 3 eine zweite Kondensatorplatte darstellt. Das Dielektrikum der zweiten Störkapazität $C_2$ ist jeweils durch eine der äußeren Keramikschichten 16 gebildet, die zwischen dem Deckel 15 und der dem jeweiligen Deckel 15 nächsten Elektrodenschicht 3 angeordnet sind.

Die zweite Störkapazität $C_2$ hat im Gegensatz zu der ersten Störkapazität $C_1$ eine sehr hohe Störwirkung und berechnet sich aus der Formel

$$C_2 = \frac{\varepsilon_0 \cdot \varepsilon_{r16} \cdot A_{16}}{d_{16}} ,$$

mit $\varepsilon_0$ als die Dielektrizitätskonstante im Vakuum, mit $\varepsilon_{r16}$ als die relative Dielektrizitätskonstante der äußeren Keramikschicht 16, $A_{16}$ als Stirnfläche der äußeren Keramikschicht 16, und $d_{16}$ als Dicke der äußeren Keramikschicht 16. Die Dicke der äußeren Keramikschicht 16 entspricht dem Abstand zwischen dem Deckel 15 und der dem jeweiligen Deckel 15 nächsten Elektrodenschicht 3.

Zur Verringerung der Störkapazitäten $C_2$ kann jeweils die Fläche $A_{16}$ und/oder die relative Dielektrizitätskonstante $\varepsilon_{r16}$ des Dielektrikums verringert und/oder die Dicke $d_{16}$ der äußeren Keramikschicht 16 erhöht werden.

Eine Erhöhung der Dicke $d_{16}$ der äußeren Keramikschichten 16 ist aus Gründen des geringen Bauraums nur in engen Grenzen und damit nur mit sehr geringer Auswirkung möglich.

Eine nennenswerte Verringerung der Fläche $A_{16}$ ist aus Gründen der mechanischen Festigkeit sowie der Leistung des Aktors nicht möglich.

Zur Verringerung der Störkapazität $C_2$ wird erfindungsgemäß die relative Dielektrizitätskonstante $\varepsilon_{r16}$ der äußeren Deckschichten 11 derart verringert, daß die äußeren Deckschichten 11 eine geringere relative Dielektrizitätskonstante $\varepsilon_{r16}$ aufweisen als die piezoelektrischen Keramikschichten 2 zwischen den äußeren Deckschichten 11.

Dazu sind die äußeren Deckschichten 11 aus einem Material hergestellt, das eine geringere relative Dielektrizitätskonstante $\varepsilon_r$ als die Keramikschichten 2 zwischen den äußeren Deckschichten 11 aufweist.

Bei diesem ersten Ausführungsbeispiel sind die äußeren Deckschichten 11 durch die äußeren Keramikschichten 16 gebildet, die aus einer piezoelektrischen Keramik hergestellt sind, deren relative Dielektrizitätskonstante $\varepsilon_r$ beispielsweise durch Zumischen von geeigneten Zusatzstoffen oder durch eine andere geeignete Veränderung der Materialzusammensetzung verringert ist. Die Zusammensetzung der Keramik der äußeren Keramikschichten 16 ist gegenüber den übrigen Keramikschichten 2 unterschiedlich, aber ähnlich ausgebildet.

Die relative Dielektrizitätskonstante $\varepsilon_r$ der äußeren Keramikschichten eines piezoelektrischen Aktors nach dem Stand der Technik ist gleich groß wie die relative Dielektrizitätskonstante $\varepsilon_r$ der Keramikschichten zwischen den äußeren Keramikschichten.

Erfindungsgemäß werden die äußeren Keramikschichten eines piezoelektrischen Aktors nach dem Stand der Technik durch äußere Keramikschichten 16 ersetzt, die eine kleinere relative Dielektrizitätskonstante $\varepsilon_{r16}$ aufweisen als die piezoelektrischen Keramikschichten 2 zwischen den äußeren Keramikschichten 16. Hierbei ist kein Zusatzprozeß bei der Herstellung des Aktors notwendig.

Die relative Dielektrizitätskonstante $\varepsilon_{r16}$ der äußeren Deckschichten 11 ist beispielsweise um den Faktor 10 bis 100 mal kleiner als die relative Dielektrizitätskonstante $\varepsilon_{r16}$ der Keramikschichten 2.

Durch die erfindungsgemäße Ausführung des piezoelektrischen Aktors können aufwendige Entstörmaßnahmen am Steuergerät 10 entfallen, beispielsweise eine Abschirmung der elektrischen Zuleitungen zum Aktor 1 oder des elektronischen Steuergerätes 10, oder sehr wirksam ergänzt werden, so daß die gleiche Entstörwirkung einfacher und kostengünstiger als beim Stand der Technik erreicht oder eine höhere Entstörwirkung bei gleich hohem Kostenaufwand wie beim Stand der Technik erzielt wird.

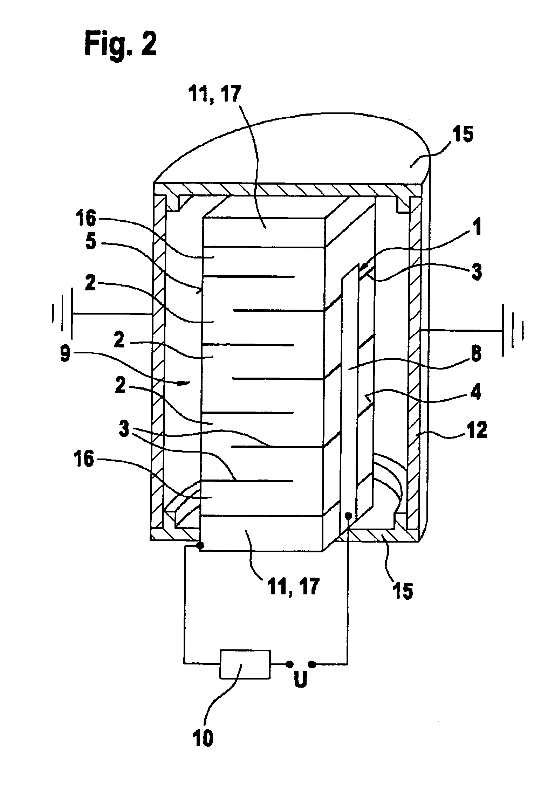

Fig.2 zeigt einen piezoelektrischen Aktor gemäß einem zweiten Ausführungsbeispiel.

Bei dem piezoelektrischen Aktor nach Fig.2 sind die gegenüber dem piezoelektrischen Aktor nach Fig.1 gleichbleibenden oder gleichwirkenden Teile durch die gleichen Bezugszeichen gekennzeichnet.

Der piezoelektrische Aktor nach Fig.2 unterscheidet sich von dem piezoelektrischen Aktor nach Fig.1 darin, daß an die äußeren Keramikschichten 16 des Aktors 1 jeweils eine zusätzliche Schicht aufgebracht ist, deren Dielektrizitätskonstante $\varepsilon_r$ geringer ist als die Dielektrizitätskonstante $\varepsilon_r$ der Keramikschichten 2 zwischen den zusätzlichen Schichten.

Bei dem zweiten Ausführungsbeispiel hat der piezoelektrische Aktor 1 äußere Keramikschichten 16, die wie beim Stand der Technik identisch wie die Keramikschichten 2 zwischen den äußeren Keramikschichten 16 zusammengesetzt sind und daher eine zumindest annähernd gleich große relative Dielektrizitätskonstante $\varepsilon_r$ haben wie die Keramikschichten 2 zwischen den äußeren Keramikschichten 16. Die äußeren Keramikschichten 16 gemäß dem zweiten Ausführungsbeispiel weisen beispielsweise eine größere Dicke als die Keramikschichten 2 zwischen den äußeren Keramikschichten 16 auf.

Erfindungsgemäß ist stirnseitig an die äußeren Keramikschichten 16 des Aktors 1 jeweils eine zusätzliche Isolierschicht 17 vorgesehen, deren relative Dielektrizitätskonstante $\varepsilon_{r17}$ kleiner ist als die relative Dielektrizitätskonstante $\varepsilon_{r2}$ der Keramikschichten 2. Die zusätzlichen Isolierschichten 17 sind beispielsweise mittels Beschichten, Kleben, Löten oder ähnlichem an den äußeren Keramikschichten 16 des Aktors 1 angeordnet und beispielsweise aus Glas, Quarz, Klebstoff, Lack, Lot, Siliziumoxid-Keramik oder ähnlich geeigneten Werkstoffen hergestellt. Die zusätzliche Isolierschicht 17 besteht aus einem starren, unelastischen Material.

Die äußere Deckschicht 11 ist bei dem zweiten Ausführungsbeispiel jeweils durch die zusätzliche Isolierschicht 17 gebildet.

Das Dielektrikum zwischen einem der beiden Deckel 15 und der dem jeweiligen Deckel 15 nächsten Elektrodenschicht 3 weist bei diesem zweiten Ausführungsbeispiel zwei Schichten auf, die äußere Keramikschicht 16 und die zusätzliche Isolierschicht 17. Dies entspricht einer Reihenschaltung von zwei Kapazitäten, so daß sich die Störkapazität $C_2$ für das zweite Ausführungsbeispiel wie folgt berechnet

$$\frac{1}{C_2} = \frac{1}{\dfrac{\varepsilon_0 \cdot \varepsilon_{r16} \cdot A_{16}}{d_{16}}} + \frac{1}{\dfrac{\varepsilon_0 \cdot \varepsilon_{r17} \cdot A_{17}}{d_{17}}}$$

mit $\varepsilon_0$ als die Dielektrizitätskonstante im Vakuum, $\varepsilon_{r16}$ als die relative Dielektrizitätskonstante der äußeren Keramikschichten 16, $A_{16}$ als Stirnfläche der äußeren Keramikschichten 16 und $d_{16}$ als die Dicke der äußeren Keramikschichten 16, $\varepsilon_{r17}$ als die relative Dielektrizitätskonstante der zusätzlichen Isolierschicht 17, $A_{17}$ als die Stirnfläche der zusätzlichen Isolierschicht 17 und $d_{17}$ als die Dicke der zusätzlichen Isolierschicht 17.

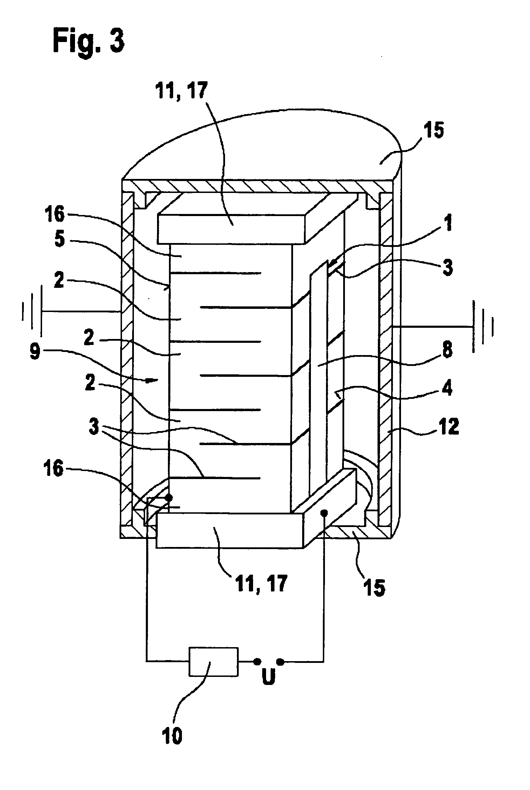

Fig.3 zeigt einen piezoelektrischen Aktor gemäß einem dritten Ausführungsbeispiel.

Bei dem piezoelektrischen Aktor nach Fig.3 sind die gegenüber dem piezoelektrischen Aktor nach Fig.1 und Fig. 2 gleichbleibenden oder gleichwirkenden Teile durch die gleichen Bezugszeichen gekennzeichnet.

Der piezoelektrische Aktor nach Fig.3 unterscheidet sich von dem piezoelektrischen Aktor nach Fig.1 und Fig.2 darin, daß die zusätzliche Isolierschicht 17 nicht mit dem Aktor 1, sondern jeweils mit einem der Deckel 15 stoffschlüssig und/oder kraftschlüssig verbunden ist.

Erfindungsgemäß weisen die Deckel 15 jeweils die zusätzliche Isolierschicht 17 auf. Die zusätzliche Isolierschicht 17 ist als äußere Deckschicht 11 jeweils an einer der äußeren Keramikschicht 16 des Aktors 1 zugewandten Stirnseite der Deckel 15 vorgesehen. Die zusätzliche Isolierschicht 17 der Deckel 15 hat gemäß dieser Ausführung beispielsweise eine gleiche große Stirnfläche wie die Keramikschichten 2 des Aktors 1 oder eine größere Stirnfläche als die Keramikschichten 2 des Aktors 1.

Die zusätzlichen Isolierschichten 17 sind beispielsweise mittels Beschichten, Kleben, Löten oder ähnlichem mit den Deckeln 15 des Zylinders 12 verbunden und beispielsweise aus Glas, Quarz, Klebstoff, Lack, Lot, Siliziumoxid-Keramik oder ähnlich geeigneten Werkstoffen hergestellt.

Gemäß dem dritten Ausführungsbeispiel hat der Aktor 1 wie in dem zweiten Ausführungsbeispiel äußere Keramikschichten 16, die beispielsweise identisch wie die Keramikschichten 2 zwischen den äußeren Keramikschichten 16 zusammengesetzt sind und daher eine zumindest annähernd gleiche relative Dielektrizitätskonstante $\varepsilon_r$ haben wie die Keramikschichten 2 zwischen den äußeren Keramikschichten 16.

Die Ausführung gemäß dem dritten Ausführungsbeispiel hat den Vorteil, daß der Aufbau des Aktors 1 unverändert bleibt und nur eine erfindungsgemäße Verbesserung an den Deckeln 15 des Zylinders 12 erfolgt.

**Patentansprüche**

1. Piezoelektrischer Aktor mit piezoelektrischen Keramikschichten, die übereinander zu einem Multilayerstapel geschichtet angeordnet sind, wobei zwischen den piezoelektrischen Keramikschichten jeweils eine Elektrodenschicht vorgesehen ist, wobei an den stirnseitigen Enden des Aktors jeweils eine äußere Deckschicht angeordnet ist, wobei die piezoelektrischen Keramikschichten und die äußeren Deckschichten jeweils eine vorbestimmte Dielektrizitätskonstante $\varepsilon_r$ aufweisen, wobei die äußeren Deckschichten (11,16,17) eine geringere relative Dielektrizitätskonstante $\varepsilon_r$ aufweisen als die piezoelektrischen Keramikschichten (2) zwischen den äußeren Deckschichten (11,16,17) und wobei die äußeren Deckschichten (11,16,17) jeweils mit einem Deckel (15) eines den Aktor (1) umgebenden Zylinders (12) verbunden sind.

2. Piezoelektrischer Aktor nach Anspruch 1, **dadurch gekennzeichnet, dass** die äußeren Deckschichten (16) mit jeweils einer Elektrodenschicht (3) benachbart sind.

3. Piezoelektrischer Aktor nach Anspruch 1, **dadurch gekennzeichnet, dass** die äußeren Deckschichten (17) jeweils an einer Keramikschicht (2) angeordnet sind.

4. Piezoelektrischer Aktor nach Anspruch 2, **dadurch gekennzeichnet, dass** die äußeren Deckschichten (16) aus einer piezoelektrischen Keramik hergestellt sind.

5. Piezoelektrischer Aktor nach Anspruch 4, **dadurch gekennzeichnet, dass** die relative Dielektrizitätskonstante $\varepsilon_r$ der Keramik der äußeren Deckschicht (16) durch Zumischen von Zusatzstoffen verringert ist.

6. Piezoelektrischer Aktor nach Anspruch 1, **dadurch gekennzeichnet, dass** die äußeren Deckschichten (17) jeweils durch Beschichten, Kleben oder Löten mit einer Keramikschicht (2) verbunden sind.

7. Piezoelektrischer Aktor nach Anspruch 1, **dadurch gekennzeichnet, dass** die äußeren Deckschichten (17) jeweils aus Quarz, einem Glas, einem Klebstoff, einem Lack, einem Lot oder Siliziumoxid-Keramik hergestellt sind.

**8.** Piezoelektrischer Aktor nach Anspruch 1, **dadurch gekennzeichnet, dass** die äußeren. Deckschichten (17) starr und unelastisch ausgebildet ist.

**Claims**

**1.** Piezoelectric actuator comprising piezoelectric ceramic layers which are arranged one above the other in layers to form a multilayer stack, wherein an electrode layer is provided between each of the piezoelectric ceramic layers, wherein an outer cover layer is arranged at each of the ends of the actuator, wherein the piezoelectric ceramic layers and the outer cover layers each have a predetermined dielectric constant $\varepsilon_r$, wherein the outer cover layers (11, 16, 17) have a lower relative dielectric constant $\varepsilon_r$ than the piezoelectric ceramic layers (2) between the outer cover layers (11, 16, 17) and wherein the outer cover layers (11, 16, 17) are each connected to a cover (15) of a cylinder (12) which surrounds the actuator (1).

**2.** Piezoelectric actuator according to Claim 1, **characterized in that** the outer cover layers (16) are each adjacent to a respective electrode layer (3).

**3.** Piezoelectric actuator according to Claim 1, **characterized in that** the outer cover layers (17) are each arranged on a ceramic layer (2).

**4.** Piezoelectric actuator according to Claim 2, **characterized in that** the outer cover layers (16) are produced from a piezoelectric ceramic.

**5.** Piezoelectric actuator according to Claim 4, **characterized in that** the relative dielectric constant $\varepsilon_r$ of the ceramic of the outer cover layer (16) is reduced by the admixture of additives.

**6.** Piezoelectric actuator according to Claim 1, **characterized in that** the outer cover layers (17) are each connected to a ceramic layer (2) by means of coating, adhesive bonding or soldering.

**7.** Piezoelectric actuator according to Claim 1, **characterized in that** the outer cover layers (17) are each produced from quartz, a glass, an adhesive, a surface coating agent, a solder or silicon oxide ceramic.

**8.** Piezoelectric actuator according to Claim 1, **characterized in that** the outer cover layers (17) have a rigid and inelastic form.

**Revendications**

**1.** Actionneur piézoélectrique comprenant des couches en céramique piézoélectriques qui sont disposées en couches superposées pour former une pile multicouche, une couche d'électrodes étant prévue à chaque fois entre les couches en céramique piézoélectriques, une couche de recouvrement extérieure étant à chaque fois disposée aux extrémités frontales de l'actionneur, les couches en céramique piézoélectriques et les couches de recouvrement extérieures présentant à chaque fois une constante diélectrique prédéterminée $\varepsilon_r$, les couches de recouvrement extérieures (11, 16, 17) présentant une constante diélectrique relative plus faible $\varepsilon_r$ que les couches en céramique piézoélectriques (2) entre les couches de recouvrement extérieures (11, 16, 17) et les couches de recouvrement extérieures (11, 16, 17) étant à chaque fois connectées à un couvercle (15) d'un cylindre (12) entourant l'actionneur (1).

**2.** Actionneur piézoélectrique selon la revendication 1, **caractérisé en ce que** les couches de recouvrement extérieures (16) sont adjacentes à une couche d'électrodes respective (3).

**3.** Actionneur piézoélectrique selon la revendication 1, **caractérisé en ce que** les couches de recouvrement extérieures (17) sont disposées à chaque fois sur une couche en céramique (2).

**4.** Actionneur piézoélectrique selon la revendication 2, **caractérisé en ce que** les couches de recouvrement extérieures (16) sont fabriquées en une céramique piézoélectrique.

**5.** Actionneur piézoélectrique selon la revendication 4, **caractérisé en ce que** la constante diélectrique relative $\varepsilon_r$ de la céramique de la couche de recouvrement extérieure (16) est réduite en ajoutant des additifs.

**6.** Actionneur piézoélectrique selon la revendication 1, **caractérisé en ce que** les couches de recouvrement extérieures (17) sont à chaque fois connectées par un revêtement, un collage ou un brasage à une couche en céramique (2).

**7.** Actionneur piézoélectrique selon la revendication 1, **caractérisé en ce que** les couches de recouvrement extérieures (17) sont fabriquées à chaque fois en quartz, en verre, en adhésif, en laque, en brasure ou en céramique d'oxyde de silicium.

**8.** Actionneur piézoélectrique selon la revendication 1, **caractérisé en ce que** les couches de recouvrement extérieures (17) sont rigides et non élastiques.

# Fig. 1

# Fig. 2

# Fig. 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19838862 A1
- WO 2005053046 A